# EUROPÄISCHE PATENTANMELDUNG

(11) **EP 0 612 097 A1**
(43) Veröffentlichungstag der Anmeldung: **24.08.1994**
(21) Anmeldenummer: 93114681.5
(22) Anmeldetag: 13.09.1993
(51) Int. Cl.: H01J 37/34

(54) **Vorrichtung zum Beschichten eines Substrats**

(30) Priorität: 16.02.1993 DE 4304581
(71) Anmelder: LEYBOLD AKTIENGESELLSCHAFT, D-63450 Hanau (DE)
(72) Erfinder: Latz, Rudolf, Dr., D-631109 Rodgau-Dudenhofen (DE)

(57) **Zusammenfassung**

Bei einer Vorrichtung zum Beschichten eines Substrats (1) mit einer Gleichstrom- und/oder eine Wechselstromquelle (10 bzw. 38), die an eine in einer evakuierbaren mit Prozeßgasen füllbaren Beschichtungskammer (15, 15a, 15b) angeordnete Elektrode (5) angeschlossen ist, die elektrisch mit Targets (3, 32) in Verbindung steht, die zerstäubt werden, weist das eine Target (3) eine im wesentlichen längliche, flache, ovale Form auf und ist außerdem von einer Dunkelraumabschirmung (34) umschlossen, deren dem Substrat (1) zugewandter, umlaufender Rand (35) geringfügig die Vorderfläche der Kathodenwanne (4) übergreift, wobei die in der Kathodenwanne (4) angeordnete, auf einem Joch (6) gehaltene Magnetanordnung aus einer mittleren, sich in Targetlängsrichtung erstreckenden Reihe von schmalen Magneten (8), einer weiteren an der Randpartie des Jochs (6) angeordneten endlosen Reihe von schmalen Magneten (7, 9) und zwei Rundmagneten gebildet ist, die sich jeweils an jedem Ende der mittleren Reihe von Magneten (8) befinden.

## Beschreibung

Die Erfindung betrifft eine Vorrichtung zum Beschichten eines Substrats, vorzugsweise mit Aluminiumoxid, mit einer Gleichstrom- und/oder einer Wechselstromquelle, die an eine in einer evakuierbaren und mit einem Prozeßgas füllbaren Beschichtungskammer angeordnete Elektrode angeschlossen ist, die elektrisch mit einem Target in Verbindung steht, das zerstäubt wird und dessen zerstäubte Teilchen sich auf dem Substrat, beispielsweise einem Kunststoffteil, niederschlagen, wobei das Target fest auf einer Magnete einschließenden Kathodenwanne angeordnet ist und in die Beschichtungskammer ein Prozeßgas einbringbar ist, wobei toroidförmige Magnetfelder durch das Target hindurchgreifen, deren Feldlinien im Bereich der Magnetpole aus der Oberfläche des Targets austreten.

Es ist eine Kathodenzerstäubungsvorrichtung bekannt (DE-OS 27 07 144; Sloan Technology Corp.), mit einer eine zu zerstäubende Fläche aufweisenden Kathode, einer Magneteinrichtung nahe der Kathode und an der der zu zerstäubenden Fläche gegenüberliegenden Seite zur Erzeugung magnetischer Kraftlinien, von denen wenigstens einige in die zu zerstäubende Fläche eintreten und aus ihr wieder heraustreten, und zwar an Schnittpunkten, die voneinander im Abstand liegen, zwischen denen die Kraftlinien kontinuierlich bogenförmige Segmente im Abstand von der zu zerstäubenden Fläche bilden, wobei letztere - zusammen mit den Kraftlinien - eine Begrenzung für einen geschlossenen Bereich bildet, wodurch ein tunnelförmiger Bereich gebildet wird, der über einem dadurch definierten Pfad auf der zu zerstaubenden Fläche liegt, wobei geladene Teilchen die Neigung zeigen, im tunnelförmigen Bereich zurückgehalten zu werden und sich entlang diesem zu bewegen, sowie mit einer Anode in Nachbarschaft zur Kathode und mit einem Anschluß der Kathode und der Anode an eine Quelle elektrischen Potentials, wobei wenigstens die zu zerstäubende Fläche innerhalb eines evakuierbaren Behälters liegt.

Bei dieser Vorrichtung ist eine Bewegungseinrichtung zur Herstellung einer Relativbewegung zwischen dem magnetischen Feld und der zu zerstäubenden Oberfläche unter Beibehaltung ihrer räumlichen Nachbarschaft vorgesehen, wobei der erwähnte Pfad die zu zerstäubende Fläche überstreicht, und zwar in einem Flächenbereich, der größer ist als der vom ruhenden Pfad eingenommene Flächenbereich.

Weiterhin ist eine Anordnung zum Beschichten eines Substrats mit Dielektrika bekannt (P 38 21 207.2; Leybold AG), die eine Gleichstromquelle aufweist, die mit einer Elektrode verbunden ist, die elektrisch mit einem Target in Verbindung steht, das zerstäubt wird und dessen zerstäubte Teilchen mit einem zugeführten Stoff eine Verbindung eingehen, die sich auf dem Substrat niederschlägt, wobei toroidförmige Magnetfelder durch das Target hindurchgreifen, deren Feldlinien im Bereich der Magnetpole aus der Oberfläche des Targets austreten. Bei dieser Anordnung ist eine Wechselstromquelle vorgesehen, deren Ausgangsspannung der Gleichspannung der Gleichstromquelle überlagert ist, wobei die elektrische Leistung der Wechselstromquelle, die der Elektrode zugeführt wird, 5 % bis 25 % der von der Gleichstromquelle der Elektrode zugeführten Leistung entspricht.

Schließlich ist bereits in einer älteren Patentanmeldung (P 39 29 695.4) eine Vorrichtung zum Beschichten eines Substrats vorgeschlagen worden, die mit einer Gleichstromund/oder einer Wechselstromquelle ausgestattet ist, die an eine in einer evakuierbaren Beschichtungskammer angeordneten Elektrode angeschlossen ist, die elektrisch mit einem Target in Verbindung steht, das zerstäubt wird und dessen zerstäubte Teilchen sich auf dem Substrat niederschlagen, wobei in die Beschichtungskammer ein Prozeßgas einbringbar ist und wobei Magnetfelder durch das Target hindurchgreifen, deren Feldlinien im Bereich der Magnetpole aus der Oberfläche des Targets austreten.

Bei dieser Vorrichtung weist das Target zwei im wesentlichen längliche, parallelepipede Teilstücke auf, wobei die Enden der beiden Teilstücke jeweils mit Hilfe von zwei bogenförmigen Targetpartien verbunden sind und so zusammen ein ringförmiges oder ovales Target bilden.

Das Target ist bei dieser Vorrichtung von einer Dunkelraumabschirmung umschlossen, deren dem Substrat zugewandter umlaufender Rand oder Stirnfläche geringfügig gegenüber der Vorderfläche des Targets zurückversetzt ist, wobei die in einer Kathodenwanne angeordnete, auf einem Joch gehaltene Magnetanordnung aus einer mittleren, sich in Targetlängsrichtung ersteckenden Reihe von schmalen Magneten, einer weiteren an der Randpartie des Jochs angeordneten endlosen Reihe von schmalen Magneten und zwei Rundmagneten gebildet ist, wobei sich jeweils einer der Rundmagnete an jedem Ende der mittleren Reihe von Magneten befindet.

Der vorliegenden Erfindung liegt nun die Aufgabe zugrunde, eine Anordnung zum stabilen Betrieb von komplizierten, reaktiven Sputterprozessen zu schaffen. Insbesondere sollen Verbindungsschichten, wie beispielsweise Al₂O₃, SiO₂, Si₃N₄, ITO, TiO₂, Ta₂O₅ mit hoher Beschichtungsrate und Qualität herstellbar sein, wobei insbesondere das den Prozeß stark beeinträchtigende Arcing vermieden werden soll.

Diese Aufgabe wird erfindungsgemäß dadurch gelöst, daß das Target zwei zueinander parallele, im wesentlichen längliche, parallelepipede Teilstücke aufweist, wobei die Enden der beiden Teilstücke über zwei bogenförmige Targetpartien verbunden sind und mit diesen zusammen einen ringförmigen bzw. ovalen Körper bilden, wobei das Target von einer Dunkelraumabschirmung umschlossen ist, deren dem Substrat zugewandter umlaufender Rand die Kathodenwanne übergreift, derart, daß der Rand einen schmalen Bereich der dem Substrat zugekehrten Stirnfläche der Kathodenwanne abdeckt, wobei sich der Rand jedoch in einem isolierenden Abstand zur Kathodenwanne erstreckt, wobei die Dunkelraumabschirmung von einem Sockel aus einem elektrisch isolierenden Werkstoff an der Wand der Prozeßkammer und/oder der Kathodenwanne gehalten ist und wobei die in einer Kathodenwanne angeordnete, auf einem Joch gehaltene Magnetanordnung aus einer mittleren, sich in Targetlängsrichtung erstreckenden Reihe von schmalen Magneten und einer weiteren, an der Randpartie des Jochs angeordneten, endlosen Reihe von schmalen Magneten gebildet ist.

Vorzugsweise werden die Magnete dazu auf einem Joch gehalten, dessen Breite und Länge geringer bemessen ist als der von der Kathodenwanne begrenzte Wannenraum, wobei in eine Ausnehmung im Joch der Zapfen eines motorisch antreibbaren Exzenters oder Kurbeltriebs eingreift und das Joch innerhalb des Wannenraums in eine hin- und hergehende Bewegung versetzt.

Weitere Merkmale und Einzelheiten sind in den Patentansprüchen näher gekennzeichnet.

Die Erfindung läßt die verschiedensten Ausführungsmöglichkeiten Zu; eine davon ist in der anhängenden Zeichnung schematisch näher dargestellt, die eine Sputteranlage mit einem zentralen von einem als ovalen Ring ausgeformten ersten Target umschlossenen zweiten Target zeigt.

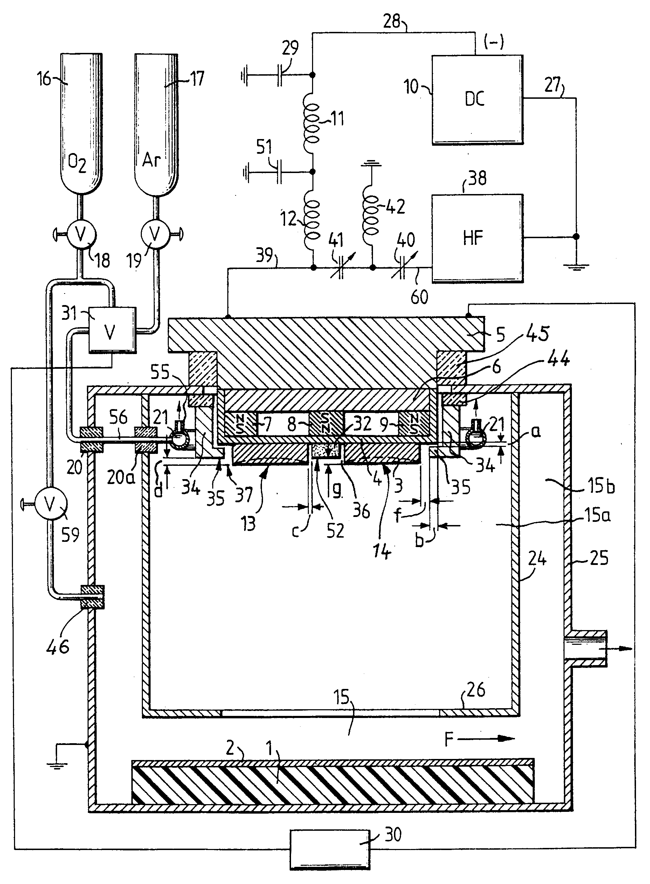

In der Zeichnung ist ein Substrat 1 dargestellt, das mit einer dünnen Metallschicht 2 versehen werden soll. Diesem Substrat 1 liegen Targets 3, 32 gegenüber, die zu zerstäuben sind. Das ringförmige Target 3, das das stabförmige Target 32 umschließt, steht über eine im Schnitt U-förmiges Element 4 (einer sogenannten Kathodenwanne) mit einer gegenüber der Prozeßkammer 25 elektrisch isolierten Elektrode 5 in Verbindung, die auf einem Joch 6 ruht, das zwischen sich und der Kathodenwanne 4 Reihen von Dauermagneten 7, 8, 9 einschließt. Die auf die Targets 3 bzw. 32 gerichteten Polaritäten der Pole der Dauermagnetreihen 7, 8, 9 wechseln sich ab, so daß jeweils die Südpole der äußeren Dauermagnetreihen 7, 9 mit dem Nordpol der mittleren Dauermagnetreihe 8 ein etwa kreisförmiges Magnetfeld durch das Target 3 bewirken. Dieses Magnetfeld verdichtet das Plasma vor dem Target 3, so daß es dort, wo die Magnetfelder das Maximum besitzen, seine größte Dichte hat. Die Ionen im Plasma werden durch ein elektrisches Feld beschleunigt, das sich aufgrund einer Gleichspannung aufbaut, die von einer Gleichstromquelle 10 angegeben wird. Diese Gleichstromquelle 10 ist mit ihrem negativen Pol über zwei Induktivitäten 11, 12 und die elektrische Leitung 39 mit der Elektrode 5 verbunden. Das elektrische Feld steht senkrecht auf der Oberfläche des Targets 3 bzw. 32 und beschleunigt die positiven Ionen des Plasmas in Richtung auf diese Targets 3, 32. Hierdurch werden mehr oder weniger viele Atome oder Partikel aus den Targets 3, 32 herausgeschlagen , und zwar insbesondere aus den strichliert eingezeichneten Gebieten (bzw. Sputtergräben) 13, 14, wo die horizontale Komponente des Magnetfeldes ihr Maximum hat. Die zerstäubten Atome oder Partikel wandern in Richtung auf das Substrat 1 zu, wo sie sich als dünne Schicht 2 niederschlagen.

Die insbesondere aus dem Target 3 herausgeschlagenen Metallpartikel reagieren in einem Raum 15 auf der Substratoberfläche mit bestimmten Gasen, die aus Gasbehältern 16, 17 über Ventile 18, 19, 31, 59 und Einlaßstutzen 20, 20a bzw. 46 und mit einer an diese angeschlossenen Ringleitung 21 mit Düsen 55 mittels Gaszuführungsleitung 56 in diesen Raum 15a bzw. 15b geleitet werden. Der Raum 15a wird durch zwei Behälter 24, 25 gebildet, von denen der eine Behälter 25 das Substrat 1 mitumfaßt und die eigentliche Prozeßkammer bildet, während der andere Behälter 24 vor dem Substrat 1 endet und als Blende 26 wirkt. Beide Behälter 24, 25 und damit auch das Substrat 1, das auf dem Boden des Behälters 25 ruht, liegen elektrisch auf Masse. An Masse liegt auch der zweite Anschluß 27 der Gleichstromquelle 10, deren erster Anschluß 28 außer an die Induktivitäten 11, 12 auch noch an Kondensatoren 29, 51 angeschlossen ist, die ihrerseits an Masse liegen.

Das Gas wird zweckmäßigerweise über ein die Kathodenwanne 4 umgebendes Gasverteilungssystem bzw. über eine Ringleitung 21 mit Düsen 55 dem zweiten Behälter 24 zugeführt und gelangt darüber hinaus auch in den Zwischenraum 15b zwischen dem ersten und dem zweiten Behälter 24, 25.

Für die Steuerung der dargestellten Anordnung kann ein Prozeßrechner 30 vorgesehen werden, der Meßdaten verarbeitet und Steuerungsbefehle abgibt. In diesem Prozeßrechner 30 können beispielsweise die Werte des gemessenen Partialdrucks in die Prozeßkammer 25 eingegeben werden. Aufgrund dieser und anderer Daten kann er zum Beispiel den Gasfluß über das Piezoventil 31 regeln und die Spannung an der Kathode 5 einstellen. Der Prozeßrechner 30 ist auch in der Lage, alle anderen Variablen, zum Beispiel Kathodenstrom und magnetische Feldstärke, zu regeln. Da derartige Prozeßrechner bekannt sind, wird auf eine Beschreibung seines Aufbaus verzichtet.

Wie die Zeichnung zeigt, sind sowohl die Kathodenwanne 4 als auch das ringförmige Target 3 mit dem zentralen Target 32 von einer Dunkelfeldabschirmung 34 umschlossen, dessen substratseitiger umlaufender Rand 35 um das Maß b über den Randbereich der Kathodenwanne 4 hinausragt. Diese Dunkelfeldabschirmung 34 kann sowohl auf Erdpotenial liegen als auch in einer besonderen Ausführungsform über einen Sockel aus isolierendem Werkstoff 44 auf dem Gehäuse 25 befestigt sein. Weiterhin befindet sich zwischen dem zentralen Target 32 und den radial inneren Flächen des Targets 3 ein Ringspalt 36 (c = 1 mm) und ebenso ein Ringspalt 37 zwischen der radial äußeren Fläche des Targets 3 und dem Rand der Dunkelfeldabschirmung 34 (f = 2 mm). Insbesondere durch den den radial außenliegenden Rand der Targetwanne 4 übergreifenden Teil der Dunkelfeldabschirmung 34 wird das unerwünschte "Arcing" vermieden (d. h. das unerwünschte sichbilden von Lichtbögen-Überschlägen).

Schließlich sei noch erwähnt, daß auch die substratseitige Stirnfläche 52 des stabförmigen zentralen Targets 32 gegenüber der kreisringförmigen Stirnfläche 13, 14 des Targets 3 um ein geringes Maß (g = 1 mm) zurückversetzt ist.

Neben der DC-Stromquelle 10 ist außerdem eine HF-Stromquelle 38 an die Stromversorgungsleitung 39 bzw. 60 mit zwischengeschalteten Kondensatoren 40, 41 und einer Induktivität 42 vorgesehen, die auch die Einspeisung eines Wechselstroms in die Elektrode 5 ermöglicht.

Bei der beschriebenen Vorrichtung ist gewährleistet, daß eine reaktive Gasentladung in einer Argon-Reaktivgasatmosphäre vor der Magnetronkathode 5 mit einem Target 3 stabil brennt. Es kann sich dabei entweder um eine Gleichspannungsentladung, eine Hochfrequenzentladung oder eine Überlagerung von beiden handeln.

Das Target 3 ist (was aus der Zeichnung nicht näher ersichtlich ist) als Langtarget (Rechtecktarget) ausgeformt, dessen Enden bogenförmig durch Kreisringstücke abgerundet sind; d. h. daß das Langtarget im Grundriß die Form eines Ovals hat (mit Parallel zueinander angeordneten länglichen parallelepipeden Seitenstücken).

Diese Konfiguration ist insbesondere für eine reine DC-Entladung empfehlenswert. Das so geformte Target 3 kann entweder auf rechteckige Standardkathodenwannen oder auf speziell mit Rundbögen hergestellte Kathodenwannen 4 aufgebracht werden.

Bei einer besonderen Ausführungsform ist das Magnetfeld derart geformt, daß der sputternde Bereich auf dem Target möglichst groß ist. Speziell für Langkathoden mit Rundbogentargets empfiehlt sich ein Magnetfeld, das von zwei Rundmagneten unterstützt wird, die an den einander diametral gegenüberliegenden Enden der mittleren Magnetreihe 8 angeordnet sind.

Die Magnetanordnung einer bevorzugten Ausführungsform zeichnet sich durch folgende Besonderheiten aus:
a) Die gewählten Magnete 7, 8, 9 sind sehr schmal (z. B. c = 5 mm) und haben eine hohe Magnetfeldstärke (Vacudym-Magnete).
b) An beiden Enden der Mittelmagnetreihe 8 sitzen zwei Rundmagnete von besonderer Größe und Stärke, so daß das Targetmaterial bei üblichen Entladespannungen bis zum Rande abgesputtert wird.

Bei einer weiteren Ausführungsform der Vorrichtung ist das Target zusammen mit dem Joch bzw. der Kathodenwanne auf der Elektrode 5 angeordnet, während die Dauermagnete bzw. Magnetreihen mit ihrem Joch mit dem Zapfen eines Kurbeltriebs gekoppelt sind (nicht näher dargestellt), der seinerseits von einer Welle antreibbar ist und über den das Joch in eine oszillierende Bewegung versetzbar ist, wobei diese Bewegungen von den Innenwänden der Kathodenwanne 4 begrenzt werden. Es ist klar, daß in diesem Falle die Abmessungen des Jochs so gewählt (kleiner) werden müssen, daß für eine oszillierende Bewegung ausreichend Platz in der Kathodenwanne verbleibt.

Bei Langkathoden ist es also möglich, bei Verwendung eines abgerundeten Targets und bei Verwendung der entsprechenden Magnetanordnung das Magnetfeld auf mindestens zweierlei Art so zu bewegen, daß selbst beim reaktiven Sputtern Belegungen an der Targetoberfläche vermieden werden, nämlich
a) durch eine seitliche Hin- und Herbewegung des gesamten Magnetjoches in der Kathodenwanne 4 und
b) durch eine gleichzeitige Bewegung des Magnetjochs in der Kathodenwanne 4 in deren Längsrichtung, so daß die Magnetanordnung sowohl in seitlicher als auch in Längsrichtung hin und her bewegt wird.

Die oben beschriebene Anordnung verhindert ebenfalls, daß sich beim reaktiven Sputtern an der Targetoberfläche isolierende Beläge bilden, durch die es zu Instabilitäten der Entladung kommen kann.

Die Vermeidung solcher Instabilitäten ist beim reaktiven Sputtern unbedingt notwendig, jedoch erfahrungsgemäß kaum unter Produktionsbedingungen zu erreichen.

Dies ist insbesondere bei einigen kritischen, reaktiven Sputterprozessen (wie z. B. die Prozesse zum Herstellen von Al₂O₃, SiO₂, Si₃N₄, ITO, TiO₂, Ta₂O₅) der Fall, insbesondere wenn hohe Sputterraten erwünscht sind.

Beim Einsatz von Magnetronkathoden wird das Sputterplasma vor den Targets mittels Magnetfelder in den sogenannten "Race Tracks" konzentriert. Dies hat zur Folge, daß von dem eingesetzten Targetmaterial bei den herkömmlichen Anordnungen nur ein kleiner Bruchteil (ca. 20-30 %) des eingesetzten Targetmaterials zerstäubt werden kann. Der prozentuale Anteil des abgestäubten Targetmaterials kann dadurch erhöht werden, daß die Bereiche die nicht sputtern durch ein anderes Material das billiger und einfacher zu bearbeiten ist, ersetzt werden. Für den Randbereich der Targets ergibt sich die Möglichkeit ein nichtsputterndes oder wenig sputterndes Targetmaterial durch einen überlappenden Dunkelraum zu ersetzen. Der Dunkelraum kann deshalb isoliert vorgesehen sein, so daß sich während des Sputterns ein floatendes, negatives Potential einstellen oder eine Spannung von außen angelegt werden kann. Dieser über den Sockel 44 isoliert aufgehängte Dunkelraum hat gegenüber dem geerdeten Duckelraum (ohne den Sockel 44) den Vorteil, daß die Entladespannung des Plasmas wesentlich geringer gehalten werden kann, weshalb z. B. ITO-Schichten mit besseren Eigenschaften hergestellt werden können. Dies ist darauf zurückzuführen, daß bei dem isolierten Dunkelraum weniger bzw. keine Elektronen vom Dunkelraum abgeleitet werden. Das negative Potential auf dem überlappenden Dunkelraum sorgt dafür, daß die Elektronen, die den seitlichen Plasmabereich erreichen, wieder ins Plasma zurückgestoßen werden und daher für weitere Ionisationen zur Verfügung stehen.

### Bezugszeichenliste

- 1: Substrat
- 2: Schicht
- 3: Target
- 4: U-förmiges Element, Kathodenwanne
- 5: Elektrode
- 6: Joch
- 7: Dauermagnet
- 8: Dauermagnet
- 9: Dauermagnet
- 10: Gleichstromquelle
- 11: Induktivität
- 12: Induktivität
- 13: Targetfläche
- 14: Sputtergraben (Gebiet)
- 15, 15a, 15b: Raum, Beschichtungskammer
- 16: Gasbehälter
- 17: Gasbehälter
- 18: Ventil
- 19: Ventil
- 20, 20a: Einlaßstutzen
- 21: Ringleitung mit Düsen
- 22: Gaszuführungsleitung
- 23: Gaszuführungsleitung
- 24: Behälter
- 25: Behälter, Prozeßkammer
- 26: Blende
- 27: elektrischer Anschluß (Masse-Leitung)
- 28: elektrischer Anschluß
- 29: Kondensator
- 30: Prozeßrechner
- 31: Ventil, Piezoventil
- 32: zweites Target
- 33: Dunkelfeldabschirmung
- 34: Randbereich
- 35: Ringspalt
- 36: Ringspalt
- 37: HF-Stromquelle
- 38: Stromversorgungsleitung
- 39: Kondensator
- 40: Kondensator
- 41: Widerstand, Induktivität
- 42: Rohrstück
- 43: Ventil
- 44: Isolator
- 45: Isoliersockel
- 46: Einlaßstutzen
- 52: substratseitige Stirnfläche
- 55: Düse
- 56: Gaszuführungsleitung
- 59: Ventil

## Patentansprüche

1. Vorrichtung zum Beschichten eines Substrats (1), vorzugsweise mit Aluminiumoxid, mit einer Gleichstrom- und/oder einer Wechselstromquelle (10 bzw. 38), die an eine in einer evakuierbaren und mit einem Prozeßgas füllbaren Beschichtungskammer (15, 15a, 15b) angeordnete Elektrode angeschlossen ist, die elektrisch mit einem Target (3, 32) in Verbindung steht, das zerstäubt wird und dessen zerstäubte Teilchen sich auf dem Substrat (1), beispielsweise einem Kunststoffteil, niederschlagen, wobei das Target (3,32) fest auf einer Magnete (7, 8,9) einschliessenden Kathodenwanne (4) angeordnet ist und wobei toroidförmige Magnetfelder durch das Target (3, 32) hindurchgreifen, deren Feldlinien im Bereich der Magnetpole (7, 8, 9) aus der Oberfläche des Targets austreten, **dadurch gekennzeichnet,** daß
a) das Target (3) zwei zueinander parallele, im wesentlichen längliche, parallelepide Teilstücke aufweist, wobei die Enden der beiden Teilstücke über zwei bogenförmige Targetpartien verbunden sind und mit diesen zusammen einen ringförmigen bzw. ovalen Körper bilden,
b) das Target (3) von einer Dunkelraumabschirmung (34) umschlossen ist, deren dem Substrat (1) zugewandter umlaufender Rand (35) die Kathodenwanne (4) übergreift, derart, daß der Rand (35) einen schmalen Bereich (b) der dem Substrat (1) zugekehrten Stirnfläche der Kathodenwanne (4) abdeckt, wobei sich der Rand (35) jedoch in einem isolierenden Abstand (a) zur Kathodenwanne (4) erstreckt,
c) die in einer Kathodenwanne (4) angeordnete, auf einem Joch (6) gehaltene Magnetanordnung aus einer mittleren, sich in Targetlängsrichtung erstreckenden Reihe von schmalen Magneten (8) und einer weiteren, an der Randpartie des Jochs (6) angeordneten, endlosen Reihe von schmalen Magneten (7, 9) gebildet wird.

2. Vorrichtung zum Beschichten eines Substrats (1), vorzugsweise mit Aluminiumoxid, mit einer Gleichstromund/oder einer Wechselstromquelle (10 bzw. 38), die an eine in einer evakuierbaren und mit einem Prozeßgas füllbaren Beschichtungskammer (15, 15a, 15b) angeordnete Elektrode angeschlossen ist, die elektrisch mit einem Target (3, 32) in Verbindung steht, das zerstäubt wird und dessen zerstäubte Teilchen sich auf dem Substrat (1), beispielsweise einem Kunststoffteil, niederschlagen, wobei das Target (3,32) fest auf einer Magnete (7, 8,9) einschliessenden Kathodenwanne (4) angeordnet ist und wobei toroidförmige Magnetfelder durch das Target (3, 32) hindurchgreifen, deren Feldlinien im Bereich der Magnetpole (7, 8, 9) aus der Oberfläche des Targets austreten, **dadurch gekennzeichnet,** daß
a) das Target (3) zwei zueinander parallele, im wesentlichen längliche, parallelepide Teilstücke aufweist, wobei die Enden der beiden Teilstücke über zwei bogenförmige Targetpartien verbunden sind und mit diesen zusammen einen ringförmigen bzw. ovalen Körper bilden,
b) das Target (3) von einer Dunkelraumabschirmung (34) umschlossen ist, deren dem Substrat (1) zugewandter umlaufender Rand (35) die Kathodenwanne (4) übergreift, derart, daß der Rand (35) einen schmalen Bereich (b) der dem Substrat (1) zugekehrten Stirnfläche der Kathodenwanne (4) überdeckt, wobei sich der Rand (35) jedoch in einem isolierenden Abstand (a) zur Kathodenwanne (4) erstreckt.
c) die Dunkelraumabschirmung (34) von einem Sockel (44) aus einem elektrisch isolierenden Werkstoff an der Wand der Prozeßkammer (25) und/oder der Kathodenwanne (4) gehalten ist,
d) die in einer Kathodenwanne (4) angeordnete, auf einem Joch (6) gehaltene Magnetanordnung aus einer mittleren, sich in Targetlängsrichtung erstreckenden Reihe von schmalen Magneten (8) und einer weiteren, an der Randpartie des Jochs (6) angeordneten, endlosen Reihe von schmalen Magneten (7, 9) gebildet wird.

3. Vorrichtung nach Anspruch 1 oder 2**, dadurch gekenn****zeichnet,** daß der umlaufende Rand (35) der geerdeten Dunkelraumabschirmung (34) mit seiner dem Substrat (1) zugekehrten Stirnfläche um ein geringes Maß (d) hinter der dem Substrat (1) zugekehrten Targetfläche (13) zurückversetzt ist.

4. Vorrichtung nach den Ansprüchen 1 oder 2 und 3, **dadurch gekennzeichnet,** daß das eine ringförmige, vorzugsweise ovale Konfiguration aufweisende Target (3) ein zweites Target (32) umschließt, das im wesentlichen stabförmig ausgebildet ist, wobei zwischen beiden Targets (3 und 32) ein umlaufender Spalt (36) vorgesehen ist und wobei das stabförmige Target (32) aus einem gegenüber dem ovalen Target (3) vergleichsweise preiswerten Werkstoff, beispielsweise Aluminium, gebildet ist.

5. Vorrichtung nach einem oder mehreren der Asprüche 1 bis 4, **dadurch gekennzeichnet,** daß das stabförmige zweite Target (32) mit der Kathodenwanne (4) verschraubt oder vernietet ist und vorzugsweise eine um das Maß (g) geringer bemessene Dicke aufweist, als das das zweite Target (32) umschließende ringförmige oder oval ausgeformte Target (3).

6. Vorrichtung nach einem oder mehreren der vorhergehenden Ansprüche, **dadurch gekennzeichnet,** daß die Magnete auf einem Joch gehalten sind, dessen Breite (B) und Länge (L) geringer bemessen sind, als der von der Kathodenwanne (4) begrenzte Wannenraum, wobei in eine Ausnehmung im Joch der Zapfen eines motorisch antreibbaren Exzenters oder Kurbeltriebs eingreift und das Joch innerhalb des Wannenraums in eine hinund hergehende Bewegung versetzt.

7. Vorrichtung nach den Ansprüchen 1 oder 2 und 3, **dadurch gekennzeichnet,** daß ein das Joch antreibender Kurbeltrieb das Joch zusammen mit den auf diesem fest angeordneten Magneten sowohl in Längsrichtung der Kathodenwanne als auch quer zu dieser bewegt.

8. Vorrichtung nach den Ansprüchen 1 oder 2 und 3 bis 4, **gekennzeichnet durch** einen Regler (30), der das Einleiten des Reaktivgases, z. B. O₂, über ein Ventil (31) derart regelt, daß die Entladespannung konstant bleibt.

9. Vorrichtung nach einem oder mehreren der vorhergehenden Ansprüche, **dadurch gekennzeichnet,** daß der Sollwert der Kathodenladespannung am Reaktivgasregler (30, 31) derart nachführbar ist, daß die Schichteigenschaft des Substrats (1) konstant bleibt.
